# EUROPEAN PATENT APPLICATION

(11) **EP 4 770 375 A1**
(43) Date of publication of application: **01.07.2026**
(21) Application number: 25225157.4
(22) Date of filing: 18.12.2025
(51) Int. Cl.: H10K 59/126, G09G 3/00, H10D 89/60

(54) **DISPLAY DEVICE**

(30) Priority: 27.12.2024 KR 20240198553
(71) Applicant: LG Display Co., Ltd., Seoul, 07336 (KR)
(72) Inventor: LEE, HyunHaeng, 10845 Paju-si (KR); LIM, Sangmoon, 10845 Paju-si (KR)
(74) Representative: Morrall, Jonathan Ian McLachlan

(57) **Abstract**

A display device in which each of a plurality of sub-pixels includes a thin film transistor including a semiconductor layer, and an equipotential line is disposed on the same layer as the semiconductor layer and includes the same material as the semiconductor layer.

## Description

### TECHNICAL FIELD

The present disclosure generally relates to a display device.

### BACKGROUND

As information society develops, demand for display devices for displaying an image is increasing in various forms. Accordingly, various display devices such as a liquid crystal display (LCD), a plasma display panel (PDP), and an organic light emitting display (OLED) have recently been used.

Among the display devices, the organic light emitting display device is a self-luminous type, and has superior viewing angles and contrast ratios compared to the liquid crystal display (LCD). In addition, since a separate backlight is not required, the organic light emitting display device can be lightweight and thin, and power consumption is advantageous. In addition, the organic light emitting display device can be driven by a DC low voltage, have a fast response speed, and are particularly inexpensive to manufacture.

### SUMMARY

In accordance with an aspect of the present disclosure, a display device is provided, including a display panel including a plurality of sub-pixels, a voltage supply unit disposed outside the display panel and supplying a high voltage to each of the plurality of sub-pixels, a gate driver disposed outside the display panel and applying a gate signal to each of the plurality of sub-pixels, an equipotential line electrically connecting the voltage supply unit and the gate driver. And, each of the plurality of sub-pixels include a light shielding layer on the substrate, a thin film transistor disposed on the light shielding layer and including a gate electrode and a semiconductor layer. And, wherein the equipotential line is disposed on a same layer as the semiconductor layer and includes a same material as the semiconductor layer

It is to be understood that both the foregoing general description and the following detailed description are exemplary and explanatory and are intended to provide further explanation of the inventive concepts as claimed.

### BRIEF DESCRIPTION OF THE DRAWINGS

The accompanying drawings, which are included to provide a further understanding of the disclosure and are incorporated in and constitute a part of this application, illustrate implementations of the disclosure and together with the description serve to explain the principle of the disclosure. In the drawings:
FIG. 1 is a block diagram of an example of a display device according to an implementation of the present disclosure.
FIG. 2 is a cross-sectional view of an example of one sub-pixel according to an implementation of the present disclosure.
FIG. 3 is an example of an enlarged view of an area A of FIG. 1.
FIG. 4 is an example of an enlarged view of an area B of FIG. 3.
FIGS. 5A to 5E are examples of cross-sectional views taken along line C-C' of FIG. 3.
FIG. 6 is an example of an enlarged view of an area B of FIG. 3.
FIGS. 7A to 7C are examples of cross-sectional views taken along line C-C' of FIG. 3.
FIG. 8 is an example of a plan view according to an implementation of the present disclosure.
FIG. 9 is an example of a plan view according to another implementation of the present disclosure.
FIG. 10 is an example of a plan view according to another implementation of the present disclosure.
FIG. 11 is an example of a cross-sectional view taken along line D-D' of FIG. 10.

Throughout the drawings and the detailed description, unless otherwise described, the same drawing reference numerals should be understood to refer to the same elements, features, and structures. The relative size and depiction of these elements may be exaggerated for clarity, illustration, and convenience

### DETAILED DESCRIPTION

Various types of inspection processes can be conducted to check defects in display devices. For example, during an inspection process, a voltage may be applied to each component of the display device. However, in this case, a potential difference may occur inside the display device due to a material difference of each component. Accordingly, a problem of damaging some components of the display device may occur.

To address this problem, a structure can be used for electrically connecting some components of the display device through an equipotential wiring, so that some components of the display device can maintain an equipotential state. However, in such scenarios, defects due to equipotential wiring can occur.

Implementations of the present disclosure can provide a display device that can achieve reduced occurrence of defects by an equipotential wiring.

Furthermore, implementations of the disclosure can provide a driving architecture for display devices that implement non-rectangular display areas near the periphery, such as rounded corners. As the display area of a display device deviates from a standard rectangular shape, the number and arrangement of light-emitting devices can become non-uniform. This can lead to challenges in the peripheral portions of the display, where a driving circuit may be connected to column lines that do not have a full set of corresponding light-emitting devices, which can cause voltage-floating artifacts and unintended light emission.

Accordingly, implementations disclosed herein can provide a display device with an improved driving architecture that can address these challenges. In some implementations, the display substrate is conceptually divided into a central area and a plurality of peripheral portions, with a first driver for the peripheral portions and a second driver for the central area. A controller circuit is connected to provide modified image data to the first driver, wherein the modified data includes black image data for driving instances that correspond to the locations of missing light-emitting devices in the peripheral portions. This application of black image data prevents the corresponding column lines from floating to an undesired voltage. This targeted driving method allows for the seamless presentation of images on a non-rectangular display without artifacts at the peripheral portions (e.g., corners). Furthermore, by preventing unintended light emission, image quality and contrast may be improved, which can contribute to a better overall user experience and potentially lower power consumption.

Advantages and features of the present specification and methods of achieving them will become apparent with reference to preferable implementations, which are described in detail, in conjunction with the accompanying drawings. However, the present specification is not limited to the implementations to be described below and may be implemented in different forms, the implementations are only provided to completely disclose the present disclosure and completely convey the scope of the present disclosure to those skilled in the art, and the present specification is defined by the disclosed claims.

Additional advantages and features of the disclosure will be set forth in part in the description which follows and in part will become apparent to those having ordinary skill in the art upon examination of the following or may be learned from practice of the disclosure. The objectives and other advantages of the disclosure may be realized and attained by the structure particularly pointed out in the written description and claims hereof as well as the appended drawings.

In addition, some implementations of the present disclosure can provide a display device capable of reducing size of a peripheral region of the display device and providing a low-power display device, due to a driver not being disposed at the periphery (e.g., a corner).

Reference will now be made in detail to implementations of the present disclosure, examples of which may be illustrated in the accompanying drawings. The progression of processing steps and/or operations described is an example; however, the sequence of steps and/or operations is not limited to that set forth herein and may be changed as is known in the art, with the exception of steps and/or operations necessarily occurring in a particular order. Names of the respective elements used in the following explanations may be selected only for convenience of writing the specification and may be thus different from those used in actual products.

Advantages and features of the present disclosure and implementation methods thereof will be clarified through following implementations described with reference to the accompanying drawings. The present disclosure may, however, be embodied in different forms and should not be construed as limited to the implementations set forth herein. Rather, these implementations are provided so that this disclosure will be thorough and complete and will fully convey the scope of the present disclosure to those skilled in the art. Further, the present disclosure is only defined by scopes of claims.

A shape, a size, a ratio, an angle and a number disclosed in the drawings for describing implementations of the present disclosure are merely an example and thus, the present disclosure is not limited to the illustrated details. Like reference numerals refer to like elements throughout the specification. In the following description, when the detailed description of the relevant known function or configuration is determined to unnecessarily obscure the important point of the present disclosure, the detailed description will be omitted. In a case where 'comprise', 'have' and 'include' described in the present disclosure are used, another portion may be added unless 'only~' is used. The terms of a singular form may include plural forms unless referred to the contrary.

In interpreting the components, it is interpreted as including the error range even if there is no separate explicit description of the error range.

In describing a position relationship, for example, when the position relationship is described as 'upon~', 'above~', 'below~' and 'next to~', one or more portions may be disposed between two other portions unless 'just' or 'direct' is used. The terms, such as "below," "lower," "above," "upper" and the like, may be used herein to describe a relationship between element (s) as illustrated in the drawings. It will be understood that the terms are spatially relative and based on the orientation depicted in the drawings.

A description of a time relationship may include a case in which the temporal precedence relationship is described as "after", "following", or "before", etc., and is not continuous unless "right away" or "directly", is used.

Although the first, second, and the like are used to describe various components, these components are not limited by these terms. These terms are used only to distinguish one component from another. Therefore, a first component mentioned below may be a second component within a technical idea of a present disclosure.

It will be understood that, although the terms "first," "second," "A," "B," "(a)," and "(b)" etc. may be used herein to describe various elements, these elements should not be limited by these terms. These terms are only used to distinguish one element from another. For example, a first element could be termed a second element, and, similarly, a second element could be termed a first element, without departing from the scope of the present disclosure.

If a component is stated to be "connected," "coupled," "connected," or "attached" to another component, that component may be connected, coupled, connected, or attached directly to that other component, but it should be understood that other components may be interposed between each component that may be connected, coupled, connected, or attached indirectly, without any specific description.

It should be understood that if a component or layer is stated to be "in contact" or "overlapping" with another component or layer, the component or layer may be in direct contact or overlapping with another component or layer, but other components may be interposed between each component that may be indirectly in contact or overlapping without particular explicit description.

The term "at least one" should be understood as including any and all combinations of one or more of the associated listed items. For example, the meaning of "at least one of a first element, a second element, and a third element" compasses the combination of all three listed elements, combinations of any two of the three elements, as well as each individual element, the first element, the second element, or the third element.

"First direction," "second direction," "third direction," "X-axis direction," "Y-axis direction," and "Z-axis direction" should not be interpreted only as a geometric relationship perpendicular to each other, but may mean that the configuration of the present disclosure has a wider direction within a range in which the configuration of the present disclosure may functionally act.

Features of each of the various implementations of the present specification may be partially or entirely coupled or combined with each other, technically various interworking and driving are possible, and each of the implementations may be independently implemented with respect to each other or may be implemented together in a related relationship.

Hereinafter, one implementation of the present disclosure will be described in detail with reference to the accompanying drawings.

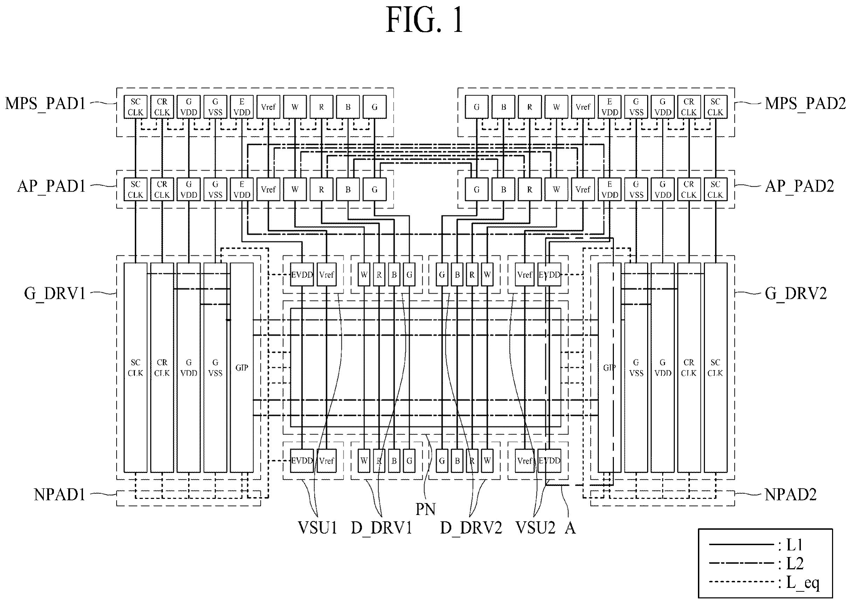

FIG. 1 is a block diagram of a display device according to an implementation of the present disclosure.

Referring to FIG. 1, the display device according to an implementation of the present disclosure may include a display panel PN, a gate driver G_DRV, a data driver D_DRV, and a voltage supply unit VSU.

The display panel PN may include a display area and a non-display area surrounding the display area. The display area is an area in which an image may be displayed, and the non-display area is an area in which an image is not displayed.

The display area may include a plurality of pixels. The plurality of pixels may be arranged in a matrix form consisting of a plurality of rows and columns. In addition, the non-display area may include a plurality of wirings, pads, and driving circuits for driving the plurality of pixels.

Each of the plurality of pixels may include a plurality of sub-pixels SP. Each of the plurality of pixels may include a plurality of sub-pixels SP that emit different light from each other. For example, each pixel may include a first sub-pixel that emits red light, a second sub-pixel that emits green light, and a third sub-pixel that emits blue light, but is not limited thereto.

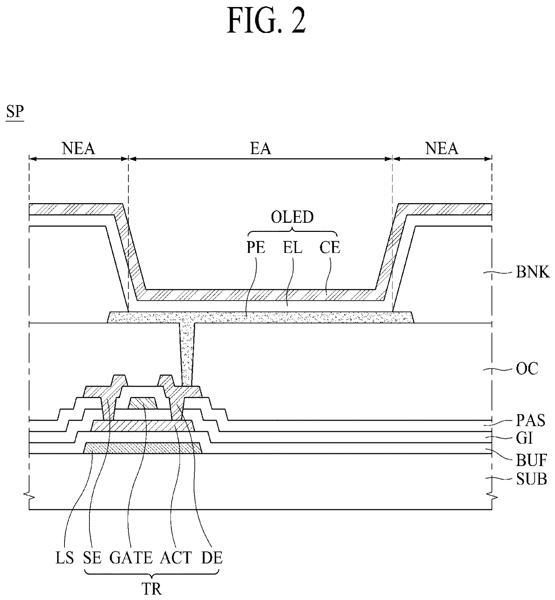

FIG. 2 is a cross-sectional view of one sub-pixel SP according to an implementation of the present disclosure.

Referring to FIG. 2, the sub-pixel SP according to an implementation of the present disclosure may include a substrate SUB, a light shielding layer LS, a buffer layer BUF, a thin film transistor TR, a passivation layer PAS, a planarization layer OC, a bank BNK, and a light emitting device OLED.

The substrate SUB may be formed of glass or plastic, but is not limited thereto. The display device according to an implementation of the present disclosure may be configured in a top emission type in which light is emitted upward. Therefore, as a material of the substrate SUB, not only a transparent material but also an opaque material may be used.

The light shielding layer LS may be disposed on the substrate SUB. The light shielding layer LS may include a conductive material capable of shielding light. For example, the light shielding layer LS may be formed of an opaque metal material such as aluminum (Al), silver (Ag), copper (Cu), molybdenum (Mo), titanium (Ti), tungsten (W), or chromium (Cr), or an alloy thereof. In addition, the light shielding layer LS is illustrated as a single layer, but may be formed as multiple layers.

The buffer layer BUF may be disposed on the substrate SUB to cover the light shielding layer LS. The buffer layer BUF may include an inorganic material such as silicon nitride (SiNx) or silicon oxide (SiOx). Although shown as a single layer, the buffer layer BUF may be formed of multiple layers. The buffer layer BUF insulates the light shielding layer LS and may improve adhesion between the layer disposed on the buffer layer BUF and the substrate SUB.

The thin film transistor TR may be disposed on the buffer layer BUF. The thin film transistor TR may be disposed at a position overlapping the light shielding layer LS. Accordingly, since the light shielding layer LS is disposed under the thin film transistor TR, a reliability of the thin film transistor TR may be improved by preventing external light from affecting the thin film transistor TR.

The thin film transistor TR may include a gate electrode GATE, a semiconductor layer ACT, a gate insulating layer GI, a source electrode SE, and a drain electrode DE.

The semiconductor layer ACT may be disposed on the buffer layer BUF. The semiconductor layer ACT may include an oxide semiconductor. For example, the semiconductor layer ACT may include at least one oxide among indium-galium-zinc-oxide (IGZO), indium-zinc-oxide (IZO), indium-galium-tin-oxide (IGTO), and indium-galium-oxide (IGO).

The gate insulating layer GI may be disposed on the semiconductor layer ACT to insulate the gate electrode GATE from the semiconductor layer ACT. The gate insulating layer GI may be formed of a single layer of silicon nitride (SiNx) or silicon oxide (SiOx), or multiple layers thereof.

The gate electrode GATE may be disposed on the gate insulating layer GI. The gate electrode GATE may be disposed on the gate insulating layer GI to overlap a channel area of the semiconductor layer ACT.

The gate electrode GATE may include a metal material such as aluminum (Al), silver (Ag), copper (Cu), molybdenum (Mo), titanium (Ti), tungsten (W), or chromium (Cr), or an alloy thereof.

The passivation layer PAS may be disposed on the gate electrode GATE and the gate insulating layer GI. The passivation layer PAS may be formed of an inorganic insulating material such as silicon oxide (SiOx), silicon nitride (SiNx), silicon oxynitride (SiOxNy), or the like.

The source electrode SE and the drain electrode DE may be disposed on the passivation layer PAS while facing each other. The source electrode SE and the drain electrode DE may be electrically connected to the semiconductor layer ACT through contact holes disposed in the passivation layer PAS and the gate insulating layer GI.

The planarization layer OC may be disposed on the thin film transistor TR. The planarization layer OC may compensate for a step difference caused by the thin film transistor TR to planarize an upper area of the thin film transistor TR. In addition, the planarization layer OC may be formed of an organic insulating material such as an acrylic resin, an epoxy resin, a phenolic resin, a polyamide resin, or a polyimide resin.

The bank BNK may be disposed on the planarization layer OC and may be disposed in the non-light emitting area NEA. The bank BNK may expose a partial area of the planarization layer OC.

The bank BNK may include an organic insulating material such as an acrylic resin, an epoxy resin, a phenolic resin, a polyamide resin, a polyimide resin, etc. Alternatively, the bank BNK may include an inorganic insulating material such as silicon oxide (SiOx), silicon nitride (SiNx), silicon oxynitride (SiOxNy), etc. In this case, the bank BNK may further include a material absorbing light. For example, the bank BNK may be a black bank.

The light emitting device OLED may be disposed on the planarization layer OC. The light emitting device OLED may include a pixel electrode PE, a light emitting layer EL, and a common electrode CE.

The pixel electrode PE may be disposed on the planarization layer OC exposed by the bank BNK. An end of the pixel electrode PE may be covered by a bank BNK. In addition, the pixel electrode PE may function as an anode of the display device. That is, the pixel electrode PE may provide holes to the light emitting layer EL.

The pixel electrode PE may be electrically connected to the thin film transistor TR through a contact hole disposed in the planarization layer OC. FIG. 2 illustrates that the pixel electrode PE is electrically connected to the drain electrode DE, but is not limited thereto. For example, the pixel electrode PE may be electrically connected to the source electrode SE.

The pixel electrode PE may include a transparent conductive material such as an indium tin oxide (ITO) or an indium zinc oxide (IZO).

The light emitting layer EL may be disposed on the pixel electrode PE. The light emitting layer EL may also be disposed on the bank BNK. That is, the light emitting layer EL may be disposed in the light emitting area EA and the non-light emitting area NEA.

The light emitting layer EL may include a hole transporting layer, an emission layer, and an electron transporting layer. In this case, when a voltage is applied to the pixel electrode PE and the common electrode CE, holes and electrons move to the emission layer through the hole transport layer and the electron transport layer, respectively, and holes and electrons may combine with each other in the emission layer to emit light.

The common electrode CE may be disposed on the light emitting layer EL. The common electrode CE may function as a cathode of the display device. Like the light emitting layer EL, the common electrode CE may also be disposed on the bank BNK. That is, the common electrode CE may be disposed in the light emitting area EA and the non-light emitting area NEA.

In implementations of the display device configured in a top emission type, the common electrode CE may include a transparent conductive material such as an indium tin oxide (ITO) or an indium zinc oxide (IZO) to transmit light emitted from the light emitting layer EL to an upper portion of the display device.

Meanwhile, referring back to FIG. 1, the gate driver G_DRV may include circuitry that supply a gate output voltage to the plurality of sub-pixels SP disposed in the display panel PN in response to a gate control signal input from a timing controller.

The gate driver G_DRV may include a first gate driver G_DRV1 provided at one side of the display panel PN and a second gate driver G_DRV2 provided at the other side of the display panel PN, but is not limited thereto. In addition, the first gate driver G_DRV1 and the second gate driver G_DRV2 may apply the same signal.

The data driver D_DRV may include circuitry that convert an image signal into a data signal of an analog format in response to a data control signal input from the timing controller and supply the data signal to the plurality of sub-pixels SP.

The data driver D_DRV may include a first data driver D_DRV1 provided at an upper side of the display panel PN and a second data driver D_DRV2 provided at a lower side of the display panel PN, but is not limited thereto. In addition, the first data driver D_DRV1 and the second data driver D_DRV2 may apply the same signal.

The voltage supply unit VSU may include various circuitry that apply a power supply voltage required to drive the plurality of sub-pixels SP. For example, the voltage supply unit VSU may supply a high voltage EVDD, a reference voltage Vref, and the like.

The voltage supply unit VSU may include a first voltage supply unit VSU1 provided at the upper side of the display panel PN and a second voltage supply unit VSU2 provided at the lower side of the display panel PN, but is not limited thereto. In addition, the first voltage supply unit VSU1 and the second voltage supply unit VSU2 may apply the same voltage.

An AP pad unit AP_PAD may be disposed outside the data driver D_DRV. An auto-probe AP inspection may be performed through circuitry in the AP pad unit AP_PAD. For example, after contacting a plurality of AP pads disposed in the AP pad unit AP_PAD with an inspection needle, an AP inspection signal may be applied to the plurality of AP pads. The AP inspection signal may be applied to the plurality of sub-pixels SP through AP inspection lines connected to the plurality of AP pads. Accordingly, it is possible to inspect whether the plurality of sub-pixels SP are turned on.

The AP pad unit AP_PAD may include a first AP pad unit AP_PAD1 and a second AP pad unit AP_PAD2 receiving the same inspection signal, but are not limited thereto.

An MPS pad unit MPS_PAD may be disposed outside the AP pad unit AP_PAD. An MPS inspection may be performed through circuitry in the MPS pad unit MPS_PAD. For example, an MPS inspection signal may be applied to a plurality of MPS pads disposed in the MPS pad unit MPS_PAD. The MPS inspection signal may be applied to the gate lines and the data lines through MPS inspection lines connected to the plurality of MPS pads. Accordingly, it is possible to inspect whether the display panel PN is defective, which may occur during actual driving.

The MPS pad unit MPS_PAD may include a first MPS pad unit MPS_PAD1 and a second MPS pad unit MPS_PAD2 that receive the same inspection signal, but is not limited thereto.

In this case, the AP inspection lines and the MPS inspection line may include a first line L1. That is, the AP inspection lines and the MPS inspection line may use the same wiring. Furthermore, the first wiring L1 may also be used as the data line.

As described above, the AP pad unit AP_PAD may include the first AP pad unit AP_PAD1 and the second AP pad unit AP_PAD2 that receive the same inspection signal. In this case, each of the first AP pad unit AP_PAD1 and the second AP pad unit AP_PAD2 can implement pads corresponding to each other that may be electrically connected through a second line L2. Accordingly, the first AP pad unit AP_PAD1 and the second AP pad unit AP_PAD2 may be stably applied with the AP inspection signal.

Furthermore, the second line L2 may be used as a wiring for an electrical connection structure between a plurality of drivers disposed in the gate driver G_DRV. Furthermore, the second line L2 may also be used as the gate line.

The first line L1 may be formed by the same process as the light shielding layer LS disposed in the sub-pixel SP described in FIG. 2. For example, the first line L1 is disposed on the same layer as the light shielding layer LS, and may include the same material. In addition, the second line L2 may be formed through the same process as the gate electrode GATE of the thin film transistor TR disposed in the sub-pixel SP described in FIG. 2. For example, the second line L2 is disposed on the same layer as the gate electrode GATE, and may include the same material. Accordingly, various wirings disposed outside the display panel PN may be configured by a metal layer formed during a manufacturing process of the sub-pixel SP.

In some implementations, a process of forming the display panel PN may include a process of forming various metal layers. For example, the process of forming the display panel PN may include a process of forming the gate electrode GATE of the thin film transistor TR described in FIG. 2. The process of forming the metal layer may include a process of depositing a metal material and a process of etching the deposited metal material.

In this case, plasma may be generated in the display panel PN by the process of etching the deposited metal material. Plasma may be applied to each component of the display device. In this case, a potential difference may occur in the display device due to a difference in materials of each component. Accordingly, a partial area of the display device may be damaged.

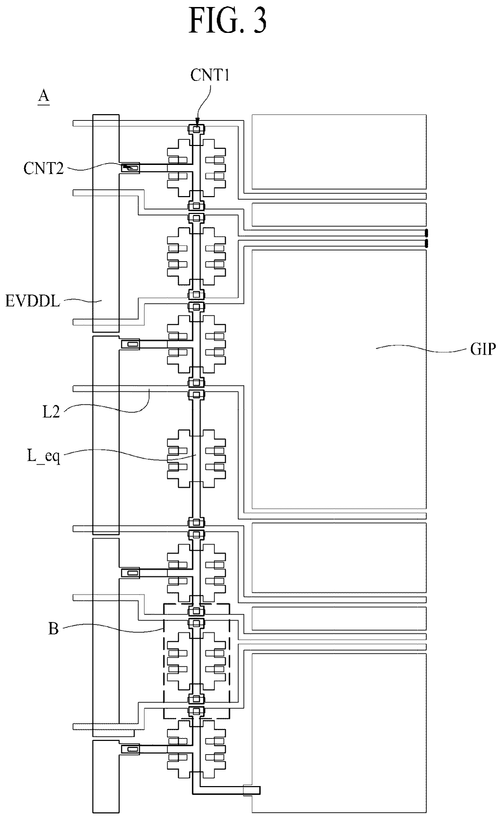

Such problems can be addressed by implementing an equipotential line L_eq. For example, the equipotential line L_eq may electrically connect the plurality of pads disposed in the MPS pad unit MPS_PAD. In addition, the equipotential line L_eq may electrically connect each of the plurality of drivers forming the gate driver G_DRV. In this case, the equipotential line L_eq may be disposed in a non-pad unit NPAD. In addition, the equipotential line L_eq may electrically connect the voltage supply unit VSU to the gate driver G_DRV. This will be described in detail with reference to FIG. 3.

The equipotential line L_eq may be formed by the same process as the semiconductor layer ACT of the thin film transistor TR disposed in the sub-pixel SP described in FIG. 2. For example, the equipotential line L_eq is disposed on the same layer as the semiconductor layer ACT, and may include the same material. Accordingly, since the equipotential line L_eq is formed by a conductive layer formed during the manufacturing process of the sub-pixel SP, the manufacturing process may be simplified.

FIG. 3 is an enlarged view of a region A of FIG. 1. In this example, FIG. 3 illustrates a structure in which the equipotential line L_eq electrically connects the voltage supply unit VSU to the gate driver G_DRV.

The equipotential line L_eq may be electrically connected to the gate driver G_DRV. In detail, the equipotential line L_eq may be electrically connected to a gate signal supply unit GIP which supplies the gate signal in the gate driver G_DRV.

As described above, the gate driver G_DRV uses the second line L2 as the gate line. That is, the second line L2 may be electrically connected to the gate driver G_DRV. Accordingly, the equipotential line L_eq may be electrically connected to the second line L2 through a first contact portion CNT1. In addition, the equipotential line L_eq may electrically connect adjacent second lines L2.

The equipotential line L_eq may be directly connected to the voltage supply unit VSU. Alternatively, the equipotential line L_eq may be electrically connected to the first line L1 connected to the voltage supply unit VSU. FIG. 3 shows a region in which the equipotential line L_eq is electrically connected to the first line L1 connected to the voltage supply unit VSU. In this case, the first line L1 connected to the voltage supply unit VSU may be specified as a high voltage line EVDDL. The equipotential line L_eq may be electrically connected to the high voltage line EVDDL through a second contact portion CNT2.

As such, since the equipotential line L_eq is electrically connected to the gate line and the high voltage line EVDDL at the same time, the gate line and the high voltage line EVDDL may be in an equipotential state. Accordingly, since the AP inspection or the MPS inspection is performed in a state in which the gate driver G_DRV and the voltage supply unit VSU are in the equipotential state, damage due to a potential difference between the gate driver G_DRV and the voltage supply unit VSU may be prevented.

Implementations of the present disclosure can provide a structure in which the equipotential line L_eq is connected to one high voltage line EVDDL through a plurality of second contact portions CNT2. Accordingly, a current generated in a process in which the equipotential line L_eq is removed may not be concentrated on a single second contact portion CNT2, but may be dispersed in the plurality of second contact portions CNT2. Accordingly, an influence on the high voltage line EVDDL may be reduced or minimized.

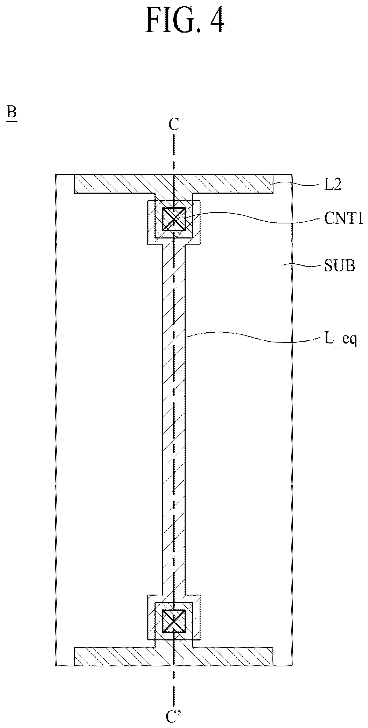

FIG. 4 is an enlarged view of an area B of FIG. 3. In detail, FIG. 4 illustrates the equipotential line L_eq disposed between the second lines L2 adjacent to each other.

Referring to FIG. 4, the second line L2 and the equipotential line L_eq may be disposed on the substrate SUB. In addition, the equipotential line L_eq may be electrically connected to the second line L2 on a one side and the other side through a contact portion CNT (e.g., a second contact portion CNT2). Accordingly, the adjacent second line L2 may maintain an equipotential state.

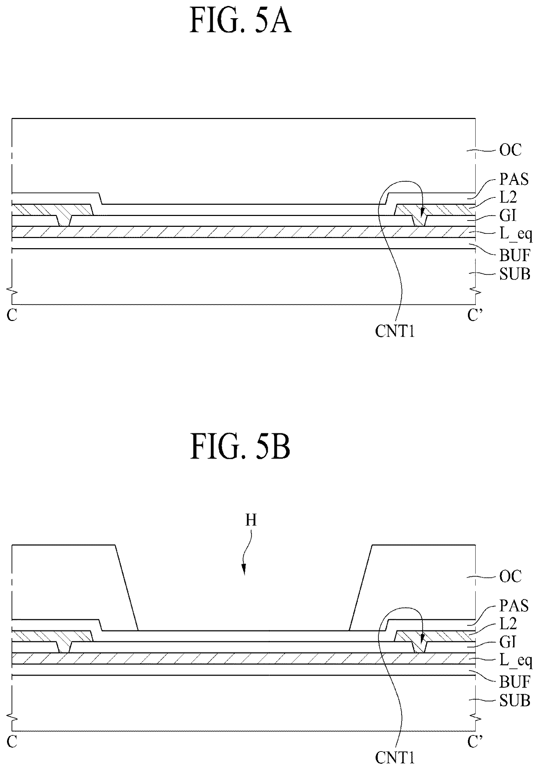

FIGS. 5A to 5E are cross-sectional views taken along line C-C' of FIG. 4. Specifically, FIGS. 5A to 5E illustrate a process of removing the equipotential line L_eq based on a cross-sectional view taken along line C-C' of FIG. 4.

As described above, the equipotential line L_eq is a wiring for stably applying the inspection signal when performing the AP inspection or the MPS inspection. Accordingly, after performing the AP inspection or the MPS inspection, the equipotential line L_eq is removed and is not disposed in the final display device.

Referring to FIG. 5A, a buffer layer BUF, an equipotential line L_eq, a gate insulating layer GI, a second line L2, a passivation layer PAS, and a planarization layer OC may be sequentially disposed on the substrate SUB.

The buffer layer BUF, the gate insulating layer GI, the passivation layer PAS, and the planarization layer OC of FIG. 5A may be disposed through the same process as the buffer layer BUF, the gate insulating layer GI, the passivation layer PAS, and the planarization layer OC provided in the sub-pixel SP described in FIG. 2. Accordingly, a description of each configuration will be omitted.

The equipotential line L_eq and the second line L2 of FIG. 5A may be formed by the same process as the semiconductor layer ACT and the gate electrode GATE of the thin film transistor TR disposed in the sub-pixel SP described in FIG. 2. Accordingly, the description of each configuration will be omitted.

As described above, the second line L2 may be electrically connected to the equipotential line L_eq through the contact portion CNT. Furthermore, the adjacent second lines L2 may be electrically connected to each other by the equipotential line L_eq. The contact portion CNT may be a contact hole penetrating the gate insulating layer GI and exposing the equipotential line L_eq.

Referring to FIG. 5B, a partial area of the planarization layer OC may be removed, and a hole H may be formed. That is, the hole H may be a space that penetrates the planarization layer OC and is surrounded by the planarization layer OC. After the hole H is formed, the remaining planarization layer OC may cover the second line L2. In addition, the hole H may expose the passivation layer PAS.

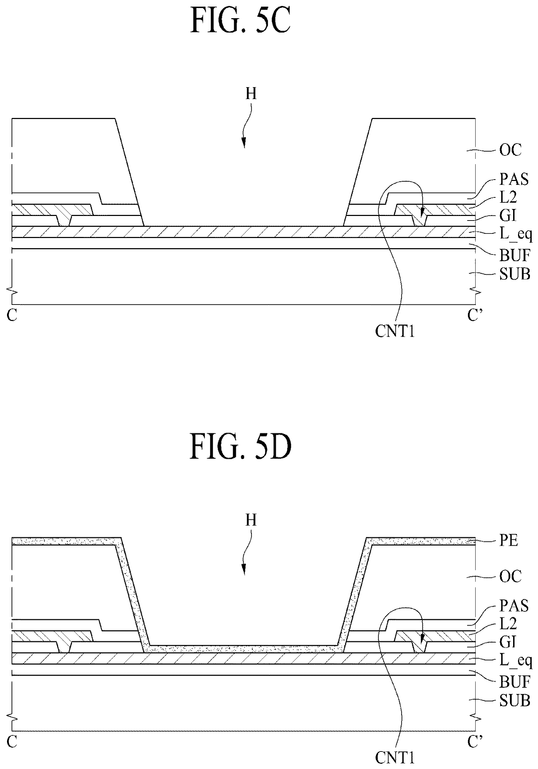

Referring to FIG. 5C, a partial area of the passivation layer PAS and the gate insulating layer GI may be removed. In this case, the passivation layer PAS and the gate insulating layer GI may be removed by using the planarization layer OC as a photoresist. Accordingly, a partial area of the passivation layer PAS and the gate insulating layer GI exposed by the planarization layer OC may be removed. The remaining passivation layer PAS and the remaining gate insulating layer GI may cover the second line L2. In addition, the hole H may expose the equipotential line L_eq.

Referring to FIG. 5D, a pixel electrode PE may be deposited on a substrate SUB. The pixel electrode PE of FIG. 5D may have the same configuration as the pixel electrode PE of the sub-pixel SP described in FIG. 2. The pixel electrode PE is deposited on the planarization layer OC, and may also be deposited in the hole H.

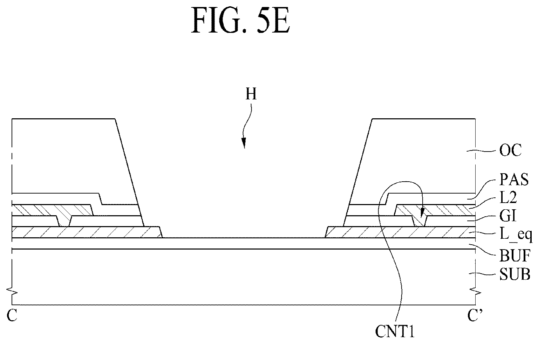

Referring to FIG. 5E, the pixel electrode PE and the equipotential line L_eq may be removed together. Since the pixel electrode PE is a configuration for emitting light of the sub-pixel SP, it may be unnecessary in an outer area of the display panel PN. Accordingly, in some implementations, the entire pixel electrode PE may be removed. In addition, a partial area of the equipotential line L_eq may be removed. For example, a partial area of the equipotential line L_eq of which an upper surface is exposed by the hole H may be removed. Accordingly, the equipotential line L_eq may be disconnected. In addition, the hole H may expose the buffer layer BUF.

As described above, the second lines L2 adjacent to each other are electrically connected by the equipotential line L_eq. However, since some areas of the equipotential line L_eq are removed, the second lines L2 adjacent to each other may not be electrically connected. That is, the second lines L2 adjacent to each other may not maintain the equipotential state. Accordingly, after the AP inspection or the MPS inspection is completed, the second lines L2 adjacent to each other may apply different gate signals from each other and may thus be driven to the display device.

By way of comparison, in an alternative type of display device, the equipotential line is formed by the same process as that of a gate electrode GATE of a thin film transistor TR. As described above in FIG. 2, the gate electrode GATE may include a metal material such as aluminum (Al), silver (Ag), copper (Cu), molybdenum (Mo), titanium (Ti), tungsten (W), or chromium (Cr), or an alloy thereof. However, the pixel electrode PE may include a transparent conductive material such as indium tin oxide (ITO) or indium Zinc oxide (IZO). As such, since the gate electrode GATE and the pixel electrode PE include materials of different chemical series, the gate electrode GATE and the pixel electrode PE may be removed using different etching solutions. Accordingly, in the alternative process of etching the pixel electrode PE, the equipotential line cannot be etched together, and a separate process for removing the equipotential line is additionally required, which can increase complexity.

On the other hand, according to implementations of the present disclosure, the equipotential line L_eq is formed by the same process as that of the semiconductor layer ACT of the thin film transistor TR. As described above in FIG. 2, the semiconductor layer ACT may include at least one conductive material among indium-galium-zinc-oxide (IGZO), indium-galium-tin-oxide (IGTO), and indium-galium-oxide (IGO). As such, since the semiconductor layer ACT and the pixel electrode PE include a material of a similar chemical series, the semiconductor layer ACT and the pixel electrode PE may be removed through the same etching solution. Accordingly, in the process of etching the pixel electrode PE, the equipotential line L_eq may be etched together and the overall process may be simplified.

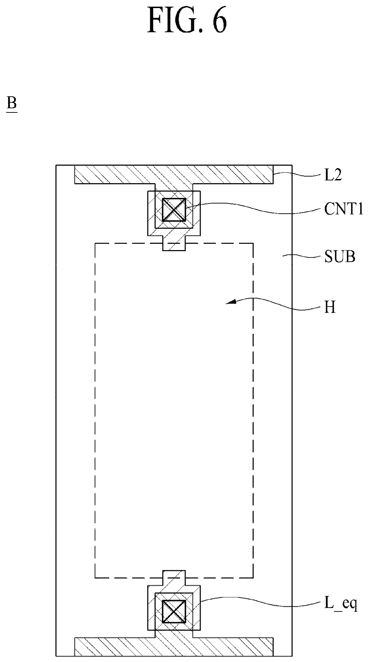

FIG. 6 is an enlarged view of an area B of FIG. 3. Specifically, a structure in which the equipotential line L_eq is removed after the process of FIGS. 5A to 5E is performed is shown.

As described above, a partial area of the equipotential line L_eq may be removed by the hole H. For example, the equipotential line L_eq may be disconnected from an area overlapping the hole H. Accordingly, the adjacent second lines L2 may not be electrically connected. In addition, since the hole H does not overlap the second line L2, the second line L2 is stably disposed and may be used as a signal line in a final display device.

In FIG. 6, a lower surface of the hole H has a rectangular shape, but is not limited thereto. For example, the lower surface of the hole H may have a circular, elliptical, or polygonal shape.

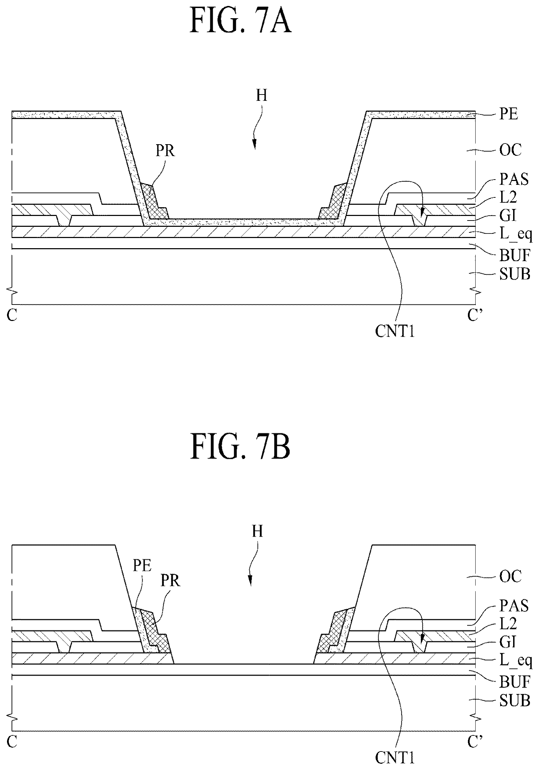

In some scenarios, a problem can occur wherein the above-described etching process of the pixel electrode PE may not proceed smoothly. This will be described in detail with reference to FIGS. 7A to 7C.

FIGS. 7A to 7C are cross-sectional views taken along line C-C' of FIG. 4. In particular, a process of etching the pixel electrode PE is illustrated in detail.

Referring to FIG. 7A, a structure before the pixel electrode PE is removed is shown. As described above, the pixel electrode PE is deposited on the planarization layer OC, and may also be deposited inside the hole H.

To etch the pixel electrode PE, a photoresist PR may be deposited. In the pixel electrodes PE, an area overlapping the photoresist PR may not be removed, and an area not overlapping the photoresist PR may be removed. As described above, since the pixel electrode PE is a configuration for emitting light of the sub-pixel SP, in some implementations it is preferable that the entire pixel electrode PE is removed from the outer area of the display panel PN. As such, it can be preferable that the photoresist PR is not deposited in the outer area of the display panel PN.

However, in some scenarios, a problem may occur wherein the photoresist PR may be deposited in an unnecessary area. For example, as shown in FIG. 7A, the photoresist PR may be deposited inside the hole H. For example, the photoresist PR may be deposited in a portion where a side surface and a lower surface of the hole H are in contact with each other. In addition, the photoresist PR may be deposited to surround the inside of the hole H.

When the process of etching the pixel electrode PE is performed in this state, as shown in FIG. 7B, the pixel electrode PE may not be entirely etched. As such, a partial area of the pixel electrode PE may remain. Due to a partial area of the photoresist PR and a partial area of the pixel electrode PE remaining, a partial area of the equipotential line L_eq may also remain.

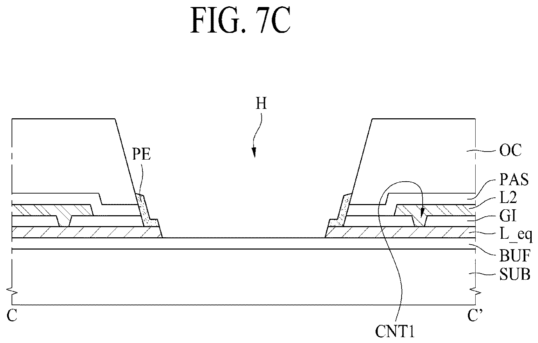

Referring to FIG. 7C, the photoresist PR may be finally removed, and a partial area of the pixel electrode PE may remain. In addition, the remaining pixel electrode PE may be in contact with the equipotential l line L_eq. As such, the remaining pixel electrode PE may be electrically connected to the equipotential line L_eq. As described above, in such scenarios, the etching process of the pixel electrode PE may not proceed smoothly.

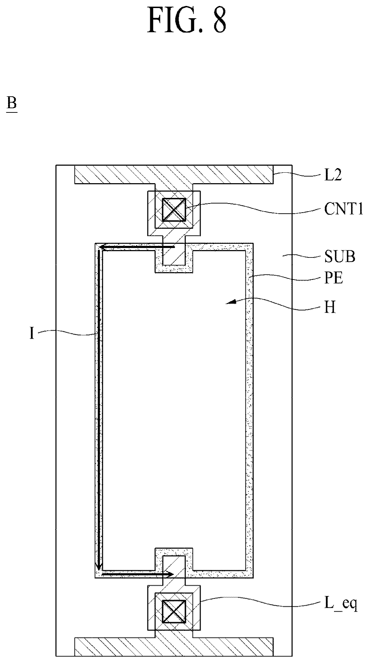

FIG. 8 is a plan view according to an implementation of the present disclosure. Specifically, FIG. 8 shows a structure in which the equipotential line L_eq is removed after the process of FIGS. 7A to 7C is performed.

Referring to FIG. 8, a structure in which the equipotential line L_eq is removed to electrically separate the second lines L2 adjacent to each other is illustrated. However, due to the problems described above, the second lines L2 adjacent to each other may be electrically connected again by the remaining pixel electrode PE.

Specifically, as described above, the remaining pixel electrode PE may be deposited to surround the inside of the hole H. In this case, the second lines L2 adjacent to each other may be electrically connected again by the remaining pixel electrodes PE. That is, when a current I flows through the second line L2 at an upper side, the current I flows along the equipotential line L_eq and the remaining pixel electrode PE, and may be applied to the second line L2 at a lower side. Accordingly, the display device cannot be driven normally.

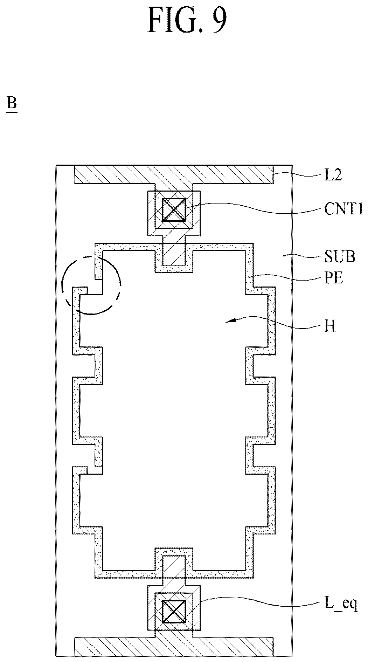

Such problems can be addressed by changing a shape of the hole H. An example is shown in FIG. 9, which is a plan view according to another implementation of the present disclosure.

Referring to FIG. 9, a side surface of the hole H may include a plurality of protrusions and a plurality of recessed portions. In this case, a length of the side surface of the hole H may increase by the plurality of protrusions and the plurality of recessed portions. As such, even when the pixel electrode PE remains in the hole H, a possibility that the pixel electrode PE is stably deposited may be reduced. In addition, a length of an electrical current path may be elongated by the increased length of the side surface due to the plurality of protrusions and the plurality of recessed portions.

In addition, even though the pixel electrode PE remains in the hole H, a partial area of the pixel electrode PE may be spaced apart from each other. For example, as shown in FIG. 9, the pixel electrode PE may not be continuously deposited at a corner where any one protrusion and any one recessed portion are in contact with each other. As such, some areas of the pixel electrode PE may be spaced apart from each other in a discontinuous manner. Accordingly, even if the pixel electrode PE remains in the hole H, the second line L2 on the upper and lower sides may still be electrically separated. Accordingly, even if the pixel electrode PE remains in the hole H, the display device may be stably driven.

The plurality of protrusions and the plurality of recessed portions along the side surfaces of the hole H may be alternately disposed, and are not limited to the structure shown in FIG. 9. In addition, FIG. 9 shows that a width of one protrusion is wider than a width of one recessed portion, but is not limited thereto.

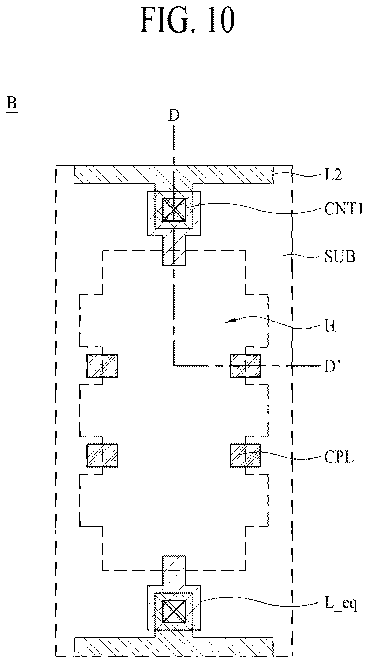

FIG. 10 is a plan view according to another implementation of the present disclosure.

Referring to FIG. 10, a step compensation layer CPL may be additionally formed. The step compensation layer CPL may help reduce a step difference between the planarization layer OC and the hole H, thereby reducing a possibility that unnecessary photoresist PR flows into the hole H. In some implementations. the step compensation layer CPL may be formed by the same process as the light shielding layer LS of the sub-pixel SP described above with reference to FIG. 2. Also, a partial area of the step compensation layer CPL may overlap the hole H. For example, the step compensation layer CPL may be disposed in an area overlapping the recessed portion along the side surface of the hole H. In this example, one side and the other side of the step compensation layer CPL are not in contact with the protrusion of the hole H, but are not limited thereto.

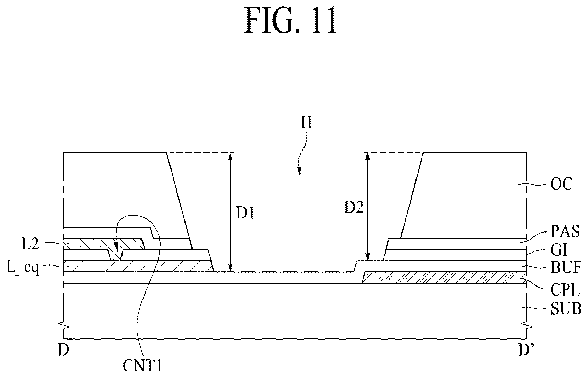

FIG. 11 is a cross-sectional view taken along line D-D' of FIG. 10.

Referring to FIG. 11, the step compensation layer CPL may be disposed between the substrate SUB and the buffer layer BUF. The step compensation layer CPL may extend toward the inside of the hole H. For example, a partial area of the step compensation layer CPL may overlap the hole H, and the remaining area may overlap the planarization layer OC. Accordingly, the step compensation layer CPL may compensate for a step difference between the planarization layer OC and the hole H.

In detail, referring to the left side of FIG. 11, a vertical distance between a top surface of the planarization layer OC and a top surface of the buffer layer BUF disposed in an area where the step compensation layer CPL is not disposed may be a first distance D1. Referring to the right side of FIG. 11, a distance between a top surface of the planarization layer OC and a top surface of the buffer layer BUF disposed in an area where the step compensation layer CPL is disposed may be a second distance D2. In this case, the first distance D1 may be greater than the second distance D2. The step compensation layer CPL can help compensate for this difference. Accordingly, since a step difference between the planarization layer OC and the hole H is reduced, a possibility that the unnecessary photoresist PR flows into the hole H may be reduced. Accordingly, a possibility that the pixel electrode PE remains in the hole H may be reduced.

A display device according to an implementation of the present disclosure includes a display panel including a plurality of sub-pixels, a voltage supply unit disposed outside the display panel and supplying a high voltage to each of the plurality of sub-pixels, a gate driver disposed outside the display panel and applying a gate signal to each of the plurality of sub-pixels, an equipotential line electrically connecting the voltage supply unit and the gate driver. And, each of the plurality of sub-pixels include a light shielding layer on the substrate, a thin film transistor disposed on the light shielding layer and including a gate electrode and a semiconductor layer. And, wherein the equipotential line is disposed on a same layer as the semiconductor layer and includes a same material as the semiconductor layer.

In the display device according to an implementation of the present disclosure, the voltage supply unit applies the high voltage to each of the plurality of sub-pixels through a first line, wherein the gate driver applies the gate signal to each of the plurality of sub-pixels through a plurality of second line, the first line is disposed on a same layer as the light shielding layer and includes a same material as the light shielding layer, and the plurality of second lines are disposed on a same layer as the gate electrode and include a same material as the gate electrode.

In the display device according to an implementation of the present disclosure, the plurality of second lines includes a 2-1st line and a 2-2nd line adjacent to each other, and the equipotential line electrically connects the 2-1st line and the 2-2nd line.

In the display device according to an implementation of the present disclosure, each of the plurality of sub-pixels includes a planarization layer on the thin film transistor and a pixel electrode on the planarization layer, and when forming the pixel electrode, the equipotential line is disconnected.

In the display device according to an implementation of the present disclosure, the pixel electrode and the equipotential line include at least one conductive material among indium-gallium-zinc-oxide (IGZO), indium-zinc-oxide (IZO), indium-gallium-tin-oxide (IGTO), and indium-gallium-oxide (IGO).

In the display device according to an implementation of the present disclosure, the pixel electrode and the equipotential line are etched together in a same process.

In the display device according to an implementation of the present disclosure, the planarization layer further includes a hole penetrating the planarization layer, and the equipotential line is disconnected by the hole.

In the display device according to an implementation of the present disclosure, a side surface of the hole includes a plurality of protrusions and a plurality of recessed portions.

In the display device according to an implementation of the present disclosure, a step compensation layer disposed outside the display panel is further comprised, a partial area of the step compensation layer overlaps the hole, and a remaining area of the step compensation layer overlaps the planarization layer.

In the display device according to an implementation of the present disclosure, the step compensation layer is disposed on a same layer as the light shielding layer and includes a same material as the light shielding layer.

In the display device according to an implementation of the present disclosure, the hole does not expose the 2-1st line and the 2-2nd line.

In the display device according to an implementation of the present disclosure, the equipotential line electrically connects the first line and the plurality of second lines.

In the display device according to an implementation of the present disclosure, the equipotential line is electrically connected to the one first line through a plurality of contact portion.

It will be apparent to those skilled in the art that the present disclosure described above is not limited by the above-described implementations and the accompanying drawings and that various substitutions, modifications and variations can be made in the present disclosure without departing from the technical ideas or scope of the disclosures. Consequently, the scope of the present disclosure is defined by the accompanying claims and it is intended that all variations or modifications derived from the meaning, scope and equivalent concept of the claims fall within the scope of the present disclosure.

## Claims

1. A display device comprising:
a display panel including a plurality of sub-pixels;
a voltage supply circuit disposed outside the display panel and configured to supply a high voltage to each of the plurality of sub-pixels;
a gate driving circuit disposed outside the display panel and configured to apply a gate signal to each of the plurality of sub-pixels; and
an equipotential line electrically connecting the voltage supply circuit and the gate driving circuit,
wherein each of the plurality of sub-pixels includes:
a light shielding layer on a substrate; and
a thin film transistor disposed on the light shielding layer and including a gate electrode and a semiconductor layer, and
wherein the equipotential line is disposed on a same layer as the semiconductor layer and includes a same material as the semiconductor layer.

2. The display device of claim 1, wherein the voltage supply circuit is configured to apply the high voltage to each of the plurality of sub-pixels through a first line,
wherein the gate driving circuit is configured to apply the gate signal to each of the plurality of sub-pixels through a plurality of second lines,
wherein the first line is disposed on a same layer as the light shielding layer and includes a same material as the light shielding layer, and
wherein the plurality of second lines are disposed on a same layer as the gate electrode and include a same material as the gate electrode.

3. The display device of claim 2, wherein the plurality of second lines includes adjacent second lines that are electrically connected to each other through the equipotential line.

4. The display device of claim 3, wherein each of the plurality of sub-pixels includes a planarization layer on the thin film transistor and a pixel electrode on the planarization layer.

5. The display device of claim 4, wherein the pixel electrode and the equipotential line include at least one conductive material among indium-gallium-zinc-oxide, IGZO, indium-zinc-oxide, IZO, indium-gallium-tin-oxide, IGTO, and indium-gallium-oxide, IGO; and/or
wherein the pixel electrode and the equipotential line are etched together in a same process.

6. The display device of claim 4, wherein the planarization layer further includes a hole penetrating the planarization layer, and the equipotential line is disconnected by the hole.

7. The display device of claim 6, wherein a side surface of the hole includes a plurality of protrusions and a plurality of recessed portions in a plan view.

8. The display device of claim 7, further comprising a step compensation layer disposed outside the display panel,
wherein a partial area of the step compensation layer overlaps the hole, and a remaining area of the step compensation layer overlaps the planarization layer outside the hole; and optionally
wherein the step compensation layer is disposed on a same layer as the light shielding layer and includes a same material as the light shielding layer.

9. The display device of any of claims 6 to 8, wherein the hole does not expose the adjacent second lines that are electrically connected to each other through the equipotential line.

10. The display device of any of claims 2 to 9, wherein the equipotential line electrically connects the first line and the plurality of second lines; and optionally
wherein the equipotential line is electrically connected to the first line through a plurality of contact portions.

11. A method of manufacturing a display device, the method comprising:
forming a high voltage line and a light shielding layer on a substrate, wherein the high voltage line is formed on a same layer as the light shielding layer and includes a same material as the light shielding layer;
forming at least one inorganic layer on the light shielding layer and the high voltage line; and
forming, on the at least one inorganic layer, an equipotential line, a plurality of gate lines, and a thin film transistor,
wherein the thin film transistor includes a gate electrode and a semiconductor layer,
wherein the plurality of gate lines are formed on a same layer as the gate electrode and include a same material as the gate electrode,
wherein the equipotential line is formed on a same layer as the semiconductor layer and includes a same material as the semiconductor layer, and
wherein the equipotential line electrically connects the high voltage line and the plurality of gate lines.

12. The method of claim 11, wherein the equipotential line is formed to interconnect adjacent gate lines among the plurality of gate lines.

13. The method of claim +11 or 12, comprising:
forming a planarization layer on the thin film transistor; and
forming a pixel electrode on the planarization layer.

14. The method of claim 13, wherein the pixel electrode and the equipotential line include at least one conductive material among indium-gallium-zinc-oxide, IGZO, indium-zinc-oxide, IZO, indium-gallium-tin-oxide, IGTO, and indium-gallium-oxide, IGO and/or
wherein the pixel electrode and the equipotential line are etched together in a same process.

15. The method of claim 13 or 14, comprising:
forming a hole through the planarization layer to create a discontinuity in the equipotential line in the hole; and optionally
wherein the hole is formed with a side surface that includes a plurality of protrusions and a plurality of recessed portions in a plan view.
